# EUROPEAN PATENT APPLICATION

(11) **EP 2 374 650 A1**
(43) Date of publication of application: **12.10.2011**
(21) Application number: 11002562.4
(22) Date of filing: 29.03.2011
(51) Int. Cl.: B60L 3/12

(54) **Device for measuring electric current and voltage on board of electric traction railroad vehicles**

(30) Priority: 09.04.2010 IT MI20100598
(71) Applicant: Tem Elettronica S.r.l., 26900 Lodi (IT); S.T.E. S.r.l., 20040 Usmate-Velate (IT)
(72) Inventor: Romanenghi, Adelio, 20059 Vimercate (IT)
(74) Representative: Mayer, Hans Benno

(57) **Abstract**

A device for measuring electric current and voltage on board of electric traction railroad vehicles, for providing operating voltage to traction drivers and signals to a power meter, comprises a current sensor arranged on a top portion of an insulating material body, housing a voltage transformer supplying, on a secondary winding thereof, an operating voltage for the traction drivers and including a second secondary winding for measuring voltage with a precision necessary for the energy power, and further including a further winding, electrically integral with the primary winding, for power supplying an electronic card for measuring current, through the current sensor, and for transmitting, through the insulating material body, by an optical fiber and a converter circuit arranged at a bottom portion, an electric signal to the power meter.

## Description

### BACKGROUND OF THE INVENTION

The present invention relates to a device having a double function of measuring line voltage and the current drained by and supplied from a train to allow energy to be metered, while providing a measurement voltage for operating traction drivers.

The device may be used on board of electric traction railroad vehicles, where the traction driver measurement voltage is fed by a conventional inductively operating transformer, with a 25 kV / 100 V or 15 kV / 100 V ratio or a transforming ratio providing a secondary voltage larger than 10 V and a secondary power of at least 50 VA.

As is known, railroad vehicles are at present power supplied from either an A.C. or D.C.

In A.C. voltage driven vehicles, the inventive device is applied to, the rated voltage may be of 25 kV at 50 Hz or 15 kV at 16.66 Hz.

Said vehicles conventionally also comprises the so-called traction drivers, a measurement inlet of which is derived from a transformer arranged on the vehicle roof, the transformer having a power sufficient to operate a plurality of parallel arranged drivers.

In addition to the above requirements, it is also necessary to provide the energy meter with a measurement of the line voltage and train drained/fed current.

The device according to the present invention synergistically provides both the above functions by a single apparatus housed in an insulating body providing, in addition to target performance, the high voltage insulation necessary to fit safety electric requirements.

Current European regulations establish performance and features the devices on board of railroad vehicles should have, both with respect to test voltage levels and procedures for testing said devices being used for line voltages up to a rated 25 kV value.

### SUMMARY OF THE INVENTION

Accordingly, the main object of the present invention is to provide a device suitable to meet all the above regulations and use requirements.

The above object, as well as further objects, which will become more apparent hereinafter, are achieved by an electric voltage and current measuring device as herein disclosed.

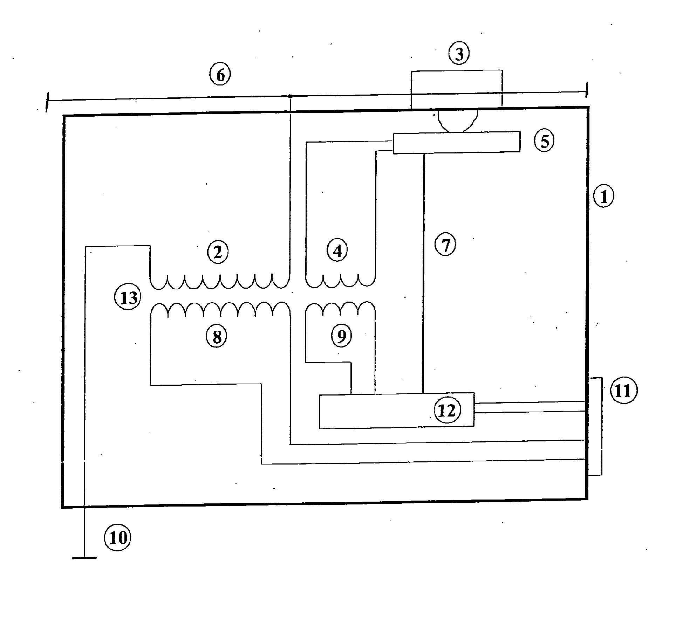

### BRIEF DESCRIPTION OF THE DRAWING

Further characteristics and advantages of the inventive device will be more apparent from the following detailed disclosure of a preferred embodiment thereof, as shown in the single drawing figure which is a schematic diagram of the inventive device.

### DESCRIPTION OF THE PREFERRED EMBODIMENT

As shown in the single drawing figure, the inductively operating voltage transformer device is embedded in an insulating body 1 and comprises a primary winding 2 and a secondary winding 4 electrically arranged near the winding 1 and power supplying an electronic card or circuit 5, receiving a measurement signal from a current sensor 3 series coupled to a line wire 6 power supplying the train, said wire 6, therethrough the train drained/supplied current passes, is integrally coupled to the winding 2, thereby the voltage between the wire 6 and ground 10 will be applied to the train, said electronic card or circuit 5 sending information from said sensor 3 through an optical fiber 7 to a second electronic card or circuit 12 receiving the signal from the optical fiber 7 and transforming it into an electric signal to be read by an energy meter, together with the signal taken from the winding 9 and suitably conditioned by the electronic card 12, a secondary winding 8 available on a connector 11 or another dedicated connector to provide the traction driver operating voltage being moreover provided.

Advantageously, the insulating body 1 of the measurement device for measuring voltage and current on board of railroad vehicles is an insulator assembly including the transformer windings whereas the current sensor 3 may be installed on the top portion of the insulating body 2 together with the electronic card 5 and related connections, as shown in the accompanying drawing.

Further advantageously, the inventive measurement device operates based on an inductively operating transformer 13, including transformer windings 8 and 9, the first of which is used for measuring voltage of the train drivers, the second power supplying an electronic circuit 12 arranged on a bottom portion of the insulating body 1, sending measurements to the power meter.

Further advantageously, the transformer 13 winding 4 is weakly insulated from the primary winding 2, and power supplies the electronic card or circuit 5 for measuring current 3 and transmitting the signal through the optical fiber 7 to the bottom portion of the insulating body 1.

In particular said transformer 13 winding 4 is arranged near the high voltage portion of the primary winding 2, the latter being connected, at an end thereof, to the high voltage wire 6 and, at the other end thereof, to the vehicle ground or earth 10.

Advantageously, said transformer 13 operates both at 50 and 16.66 Hz, while assuring the same minimum performance both with respect to the power and the measurement precision. The electronic circuit 5, power supplied by the winding 4, receives a signal proportional to the current drained/supplied by the current sensor 3 and performs a digital conversion of the signal, by a known method, while transmitting the converted signal, through the optical fiber 7 to the electronic circuit 12.

The latter, if required, may process the received current signal, to be eventually transformed into an electric analogic signal and, if required, transmit in an electric form the digital signal. The electric circuit 12 receives, moreover, the electric line voltage signal, from the winding 9 of the transformer 13 and it may send said signal, if required, directly to the power meter, on board of the train, through the connector 11 or process it, if required, to transform by known methods said signal into a digital signal.

Finally, the circuit 12 may also process both the received voltage and current signals to calculate therefrom target parameters, such as power and energy measurement parameters.

All the functions performed by the circuit 12 are not mutually exclusive ones.

Actually, the measurements performed by the electronic circuit 5 and processed by the electronic circuit 12 may be, if required, redundant measurements or two identical circuits, of a type 5 or of a type 12, may be used, for performing the same functions and using two optical fibers 7 to increase the device operating reliability.

## Claims

1. A device for measuring electric current and voltage on board of electric traction railroad vehicles, for providing operating voltage to traction drivers and signals to a power meter, **characterized in that** said device comprises an electric transformer (13) supporting insulating body (1) supporting an electric transformer (13) having a primary winding (2) coupled between a high voltage (6) and a ground (10), and one or more optical fibers (7), wherein a winding (4) power supplies a first high voltage (6) connected electronic circuit (5) receiving a current measuring signal from a current sensor (3) clamped on a head of said insulating body (1), said electronic circuit (5) transmitting the digitally converted current signal through a said optical fiber (7) to a second electronic circuit (12) arranged at a foot portion of said insulating body (1), said electronic circuit (12) receiving a voltage signal from a secondary winding (9) of said transformer (13) and providing an output connector (11) with voltage and current signals, processed by a per se known processing methods, to be used by a power meter on board of said railroad vehicle, a transformer (13) secondary winding (8) providing said output connector (11) with an output voltage for operating said traction drivers.

2. A device according to claim 1, **characterized in that** said transformer (13) provides a same operating performance both at 50 Hz and at 16.66 Hz.

3. A device according to claim 1, **characterized in that** said electronic circuit (5) is supplied by said transformer (13) winding (4), said circuit (5) being so controlled by the signal of said current sensor (3) on said insulating body (1) head as to measure an electric current drained/returned by said railroad vehicle.

4. A device according to claim 1, **characterized in that** said first electronic circuit (5) transmits, through said one or more optical fibers (7), said digitally converted signal to said second electronic circuit (12) arranged at said foot portion of said insulating body (1).

5. A device according to claim 3, **characterized in that** said railroad vehicle drained/returned current is measured by said electronic circuit (5) being coupled to a traction-line high voltage (6).

6. A device according to claim 1, **characterized in that** said transformer (13) comprises a transformer secondary winding (8) providing an output voltage to said traction drivers.
